# EUROPÄISCHE PATENTSCHRIFT

(11) **EP 0 614 273 B1**
(45) Veröffentlichungstag und Bekanntmachung des Hinweises auf die Patenterteilung: **16.04.1997**
(21) Anmeldenummer: 94101513.3
(22) Anmeldetag: 02.02.1994
(51) Int. Cl.: H03H 11/12

(54) **Filterschaltung mit einem in Serienresonanz betriebenen Resonator**
Filtering circuit with a resonator in series resonance
Circuit de filtrage comportant un résonateur fonctionnant comme circuit résonant en série

(30) Priorität: 03.03.1993 DE 4306511
(43) Veröffentlichungstag der Anmeldung: 07.09.1994
(73) Patentinhaber: TEMIC TELEFUNKEN microelectronic GmbH, 74072 Heilbronn (DE)
(72) Erfinder: Böhme, Rolf, Dr. Dipl.-Ing., D-74177 Bad Friedrichshall (DE); Hirsch, Konrad, Dipl.-Ing., D-85356 Freising (DE); Burkhard, Johann, Dipl.-Phys., D-89284 Pfaffenhofen (DE); Traub, Johann, Dipl.-Ing. (FH), D-89415 Lauingen (DE)
(74) Vertreter: Maute, Hans-Jürgen, Dipl.-Ing.

(56) Entgegenhaltungen:
- EP-A- 0 313 189

## Beschreibung

Filterschaltungen mit Resonatoren werden beispielsweise in schmalbandigen, hochverstärkenden Geradeausempfängern, in ZF-Verstärkern oder in batteriebetriebenen Langwellenempfängern für Zeitzeichensender eingesetzt. Die hierbei verwendeten Resonatoren (insbesondere piezoelektrische Resonatoren, bsp. Quarzresonatoren), zeichnen sich einerseits durch eine eng benachbarte Folge von Serien- und Parallelresonanz und andererseits durch hohe Resonanzgüten aus. In den meisten Anwendungsfällen ist jedoch nur eine einfache Serienresonanz oder Parallelresonanz erwünscht. Insbesondere wird für den Einsatz von Filterschaltungen bei relativ niedrigen Frequenzen die Serienresonanz genutzt, da die bei höherer Frequenz liegende Parallelresonanz wegen ihrer Hochohmigkeit praktisch unbrauchbar ist. Damit die reine Serienresonanz in Erscheinung tritt, muß die (immer vorhandene) parasitäre Parallelkapazität des Resonators kompensiert werden.
Hierzu wird in der DE-PS 35 16 810 ein Empfänger für Zeitzeichensignale mit einem in Brückenschaltung ausgebildeten Filter beschrieben; dieser bekannte Empfänger weist einen Verstärker mit zwei um 180° gegeneinander phasenverschobenen Ausgängen auf, wobei der eine Ausgang über einen Resonator und der andere Ausgang über einen Kompensationskondensator mit dem Eingang des Folgeverstärkers verbunden ist. Entspricht die Kapazität des Kompensationskondensators der wirksamen Parallelkapazität des Resonators, wird diese kompensiert und dadurch das erwünschte einfache Resonanzverhalten erzielt. Nachteilig an dieser Anordnung ist jedoch zum einen die unsymmetrische Arbeitsweise, die infolge der hohen Resonatorimpedanz leicht zu Störungen führt; zum andern können die benötigten hohen Eingangswiderstände (da die Bandbreite des Filters durch den Eingangswiderstand des Folgeverstärkers bestimmt wird, sind für eine ausreichende Bandbreite hohe Werte des Eingangswiderstandes erforderlich) mit integrierten Schaltungen nur sehr aufwendig und nicht stabil genug realisiert werden.

Es ist die Aufgabe der Erfindung, eine Filterschaltung anzugeben, bei der die genannten Nachteile vermieden werden und die vorteilhafte Eigenschaften aufweist.
Gemäß der Erfindung wird diese Aufgabe durch die Merkmale des Anspruchs 1 gelöst.
Vorteilhafte Weiterbildungen der Filterschaltung ergeben sich aus den Unteransprüchen.

Die Schaltungsanordnung und Wirkungsweise der Filterschaltung soll anhand der Figuren 1 - 4 näher beschrieben werden; dabei zeigen:
- Fig. 1:: das Prinzipschaltbild der Filterschaltung,
- Fig. 2:: ein Ausführungsbeispiel der Filterschaltung,
- Fig. 3a - 3d:: verschiedene Ausführungsbeispiele der Kompensationsschaltung,
- Fig. 4:: ein weiteres Ausführungsbeispiel der Filterschaltung mit reduziertem Rauschanteil.

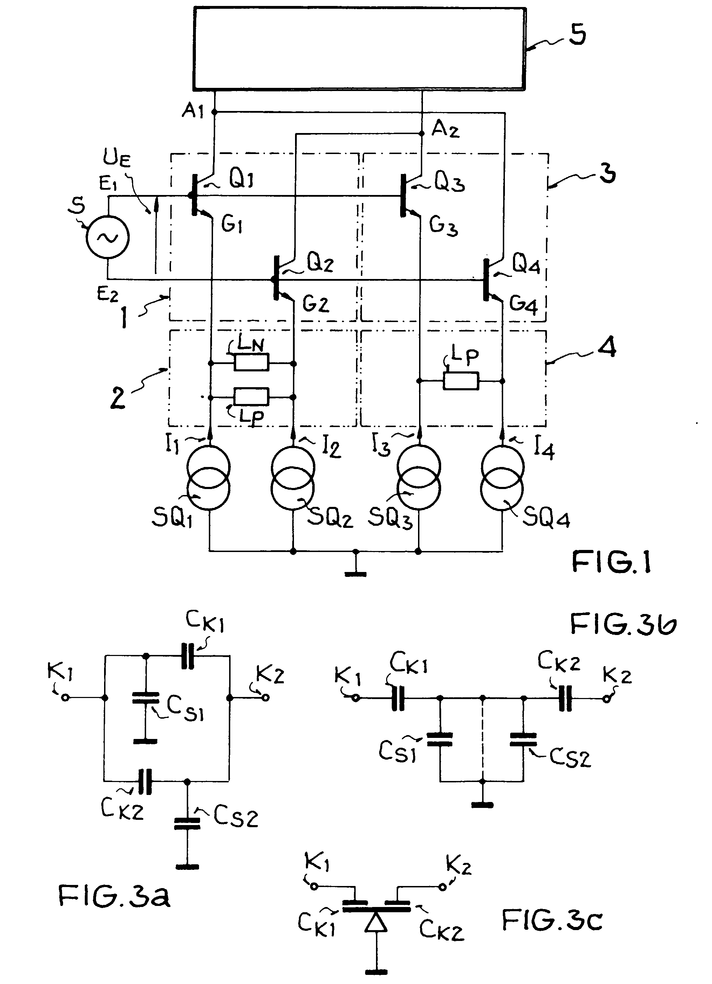

Wie im Prinzipschaltbild der Figur 1 dargestellt, weist die Filterschaltung eine erste Differenzstufe 1, eine Zweipol-Resonatorschaltung 2, eine zweite, zur ersten Differenzstufe 1 gleichartige Differenzstufe 3, eine Kompensationsschaltung 4 und eine Auswerteschaltung 5 auf. Die erste Differenzstufe 1 weist zwei aktive Elemente Q₁, Q₂ mit den Eingangsanschlüssen E₁, E₂, den Ausgangsanschlüssen A₁, A₂ und den Grundanschlüssen G₁, G₂ auf. Die Resonatorschaltung 2 enthält einen beispielsweise als Quarzresonator ausgebildeten Resonator (dessen Leitwert L_{R} in einen Nutzanteil L_{N} und einen parasitären Anteil L_{P} aufgeteilt werden kann). Die zweite Differenzstufe 3 weist zwei aktive Elemente Q₃, Q₄ mit den Eingangsanschlüssen E₁, E₂, den Ausgangsanschlüssen A₁, A₂ und den Grundanschlüssen G₃, G₄ auf, wobei die Ausgangsanschlüsse der zweiten Differenzstufe 3 gegenüber denjenigen der ersten Differenzstufe vertauscht sind. Die Kompensationsschaltung 4 (diese bildet den parasitären Anteil L_{P} des Resonator-Leitwerts L_{R} nach) besitzt zwei Anschlüsse und weist beispielsweise einen Kompensationskondensator bzw. eine Kondensatorschaltung auf. Die Auswerteschaltung 5 wird beispielsweise durch Arbeitswiderstände realisiert. Die Eingangsanschlüsse E₁, E₂ der ersten Differenzstufe 1 und der zweiten Differenzstufe 3 sind an eine die Eingangsspannung U_{E} liefernde symmetrische Spannungsquelle S angeschlossen. Jeweils ein Grundanschluß G₁, G₂ der ersten Differenzstufe 1 ist mit einem Anschluß der Resonatorschaltung 2 und mit den beiden Stromquellen SQ₁, SQ₂ (diese liefern die beiden Versorgungsströme I₁, I₂) verbunden; jeweils ein Grundanschluß G₃, G₄ der zweiten Differenzstufe 3 ist mit einem Anschluß der Kompensationsschaltung 4 und mit den beiden Stromquellen SQ₃, SQ₄ (diese liefern die beiden Versorgungsströme I₃, I₄) verbunden. Die Auswerteschaltung 5 ist an die Ausgangsanschlüsse A₁, A₂ der ersten Differenzstufe 1 und der zweiten Differenzstufe 3 angeschlossen. Die Resonatorschaltung 2 und die Kompensationsschaltung 4 können Vorwiderstände aufweisen, die einseitig oder beidseitig mit den beiden Anschlüssen der Resonatorschaltung 2 bzw. der Kompensationsschaltung 4 verbunden werden können.
Bei Verwendung von Bipolartransistoren als aktive Elemente der beiden Differenzstufen (für Feldeffekttransistoren gilt Entsprechendes) ist der differentielle Ausgangsstrom der Differenzstufe 1 umgekehrt proportional zur Summe aus Impedanz Z_{R} des Resonators der Resonatorschaltung 2, Emitter-Eingangswiderstände der Transistoren der Differenzstufe 1 und ggf. Vorwiderstände der Resonatorschaltung; die Emitter-Eingangswiderstände können gegebenenfalls so gewählt werden, daß keine Vorwiderstände nötig sind. Am Punkt der Serienresonanz wird die Verstärkung der Differenzstufe 1 maximal, die Impedanz Z_{R} des Resonators geht auf den kleinen Serienresonanzwiderstand zurück; dieser ist bei einer typischen Dimensionierung wesentlich niedriger als die Summe der beiden Emitter-Eingangswiderstände und ggf. der Vorwiderstände. Oberhalb der Serienresonanz nimmt die Impedanz Z_{R} des Resonators rasch zu, die Verstärkung der Differenzstufe 1 geht zurück (bei der 3-dB-Grenzfrequenz ist die Summe der beiden Emitter-Eingangswiderstände und der Vorwiderstände gleich dem Betrag der Impedanz Z_{R} des Resonators); an der Parallelresonanzstelle weist die Selektionskurve des Resonators einen Dämpfungspol auf, bei höheren Frequenzen sinkt die Dämpfung wieder ab. Durch die Kompensationsschaltung 4 wird der parasitäre Resonator-Leitwert L_{P} nachgebildet; die zweite Differenzstufe 3 liefert einen kapazitiv bewerteten Strom, der durch die gegenüber der ersten Differenzstufe 1 vertauschten Ausgangsanschlüsse A₁, A₂ in umgekehrter Phasenlage dem Ausgangsstrom der ersten Differenzstufe 1 zugefügt wird. Hierdurch wird zum einen die durch die Parallelkapazität des Resonators bestimmte Stromkomponente kompensiert und zum andern der Dämpfungspol in der Selektionskurve ins Unendliche verschoben; man erhält somit das Verhalten des einfachen (Serien-)Resonanzkreises.
Die Bandbreite der Filterschaltung ist von den Emitter-Eingangswiderständen und damit vom Emitterstrom der beiden Transistoren der Differenzstufe 1 abhängig; über die Vorgabe der Ströme I₁, I₂ der beiden Stromquellen SQ₁, SQ₂ kann der Emitterstrom und demzufolge auch die Bandbreite der Filterschaltung eingestellt werden. Über die Ströme I₃, I₄ der beiden Stromquellen SQ₃, SQ₄ wird die Steilheit der zweiten Differenzstufe 3 eingestellt; hierdurch können die Kompensationseffekte variiert und Streuungen in der Kompensationsschaltung 4 (bsp. des Kompensationskondensators) und der Parallelkapazität des Resonators ausgeglichen werden.
Ein Abschalten der Ströme I₁, I₂, I₃, I₄ der Stromquellen SQ₁, SQ₂, SQ₃, SQ₄ hat zur Folge, daß der Signalweg von der Stromquelle zur Auswerteschaltung unterbrochen und die Filterschaltung unwirksam wird; ordnet man mehrere Filterschaltungen so an, daß sie von der gleichen Signalquelle gespeist werden und auf die gleiche Ausgangsschaltung arbeiten, kann auf diese Weise zwischen verschiedenen Filterschaltungen umgeschaltet werden.

Die erfindungsgemäße Filterschaltung vereinigt mehrere Vorteile in sich:
- eine symmetrische Arbeitsweise wird bereits durch den Aufbau der Schaltungsanordnung implizit festgelegt,
- ein wohldefinierter, relativ hoher Eingangswiderstand ist nicht erforderlich,
- es ist ein großer Versorgungsspannungsbereich gegeben: die Filterschaltung kann bei niedrigen sorgungsspannungen bis herunter zu etwa 1 V eingesetzt werden, insbesondere wenn die Stromquellen als Transistorstromquellen mit niedriger Restspannung ausgebildet sind,
- der Stromverbrauch ist sehr gering: die Filterschaltung benötigt sehr wenig Strom, insbesondere wenn der Resonator hochohmig ist oder wenn die Bandbreite der Filterschaltung größer gewählt wird,
- sie besitzt ein vorteilhaftes Aussteuerungsverhalten: die Filterschaltung ist am Resonanzpunkt (bedingt durch die Kennlinie bipolarer Transistoren) bis etwa 20 mV Eingangsspannung aussteuerbar; außerhalb des Resonanzpunktes wirkt die ansteigende Impedanz des Resonators als Gegenkopplung, so daß entsprechend größere Aussteuerungen möglich sind (dies entspricht der nachrichtentechnischen Aufgabe, ein schwaches Nutzsignal von unerwünschten und mitunter sehr viel stärkeren Signalen zu selektieren),
- bei einer Integration der Filterschaltung ist eine geringe Anschlußkapazität gegeben: wird die Schaltung als integrierte Schaltung mit extern angeschlossenem Resonator ausgeführt, ist dieser nur mit der Hälfte der Pin-Kapazität belastet, weil die parasitären Pin-Kapazitäten beider Resonator-Anschlüsse durch den symmetrischen Betrieb als Reihenschaltung wirken (in einer unsymmetrischen Schaltung geht dagegen die volle Pin-Kapazität ein).

Gemäß dem in der Figur 2 dargestellten Ausführungsbeispiel der Filterschaltung ist die erste Differenzstufe 1 als erstes Transistorpaar mit den beiden NPN-Transistoren Q₁, Q₂ und die zweite Differenzstufe 3 als zweites Transistorpaar mit den beiden NPN-Transistoren Q₃, Q₄ ausgebildet. Die miteinander verbundenen Basen der Transistoren Q₁, Q₃ sind an den ersten Anschluß (Eingangsanschluß E₁) der die Eingangs-Wechselspannung U_{E} liefernden Signalquelle S angeschlossen, die miteinander verbundenen Basen der Transistoren Q₂, Q₄ sind an den zweiten Anschluß (Eingangsanschluß E₂) der Signalquelle S angeschlossen. Mit den Emittern der beiden Transistoren Q₁, Q₂ des ersten Transistorpaares (Grundanschlüsse G₁, G₂) ist jeweils ein Anschluß der Resonatorschaltung 2 (mit dem als piezoelektrischer Quarzresonator X_{R} ausgebildeten Resonator und mit den Vorwiderständen R_{V1}, R_{V2}) verbunden; die Emitter der Transistoren Q₃, Q₄ des zweiten Transistorpaares (Grundanschlüsse G₃, G₄) sind mit jeweils einem Anschluß K₁ bzw. K₂ der Kompensationsschaltung 4 (die den Kompensationskondensator C_{K} und die Vorwiderstände R_{V3}, R_{V4} aufweist) verbunden. Die Emitter der Transistoren Q₁, Q₂, Q₃ und Q₄ werden jeweils von einer Stromquelle SQ₁, SQ₂, SQ₃ und SQ₄ gespeist, die auf übliche Weise als Transistor-Stromquellen oder durch hochohmige Widerstände ausgeführt sein können. Der erste Ausgangsanschluß A₁ der Schaltungsanordnung wird durch die Verbindung der Kollektoren der Transistoren Q₁ und Q₄, der zweite Ausgangsanschluß A₂ durch die Verbindung der Kollektoren der Transistoren Q₂ und Q₃ gebildet; an die Ausgangsanschlüsse A₁, A₂ ist die Auswerteschaltung 5 in Form von Arbeitswiderständen R₁, R₂ angeschlossen. Die zweite Differenzstufe 3 mit den Transistoren Q₃, Q₄ liefert einen kapazitiv bewerteten Strom, der durch die gegenüber der ersten Differenzstufe 1 vertauschten Ausgangsanschlüsse A₁, A₂ in umgekehrter Phasenlage dem Ausgangsstrom der ersten Differenzstufe 1 zugefügt wird und infolgedessen die durch die Parallelkapazität des Resonators erzeugte Stromkomponente kompensiert.

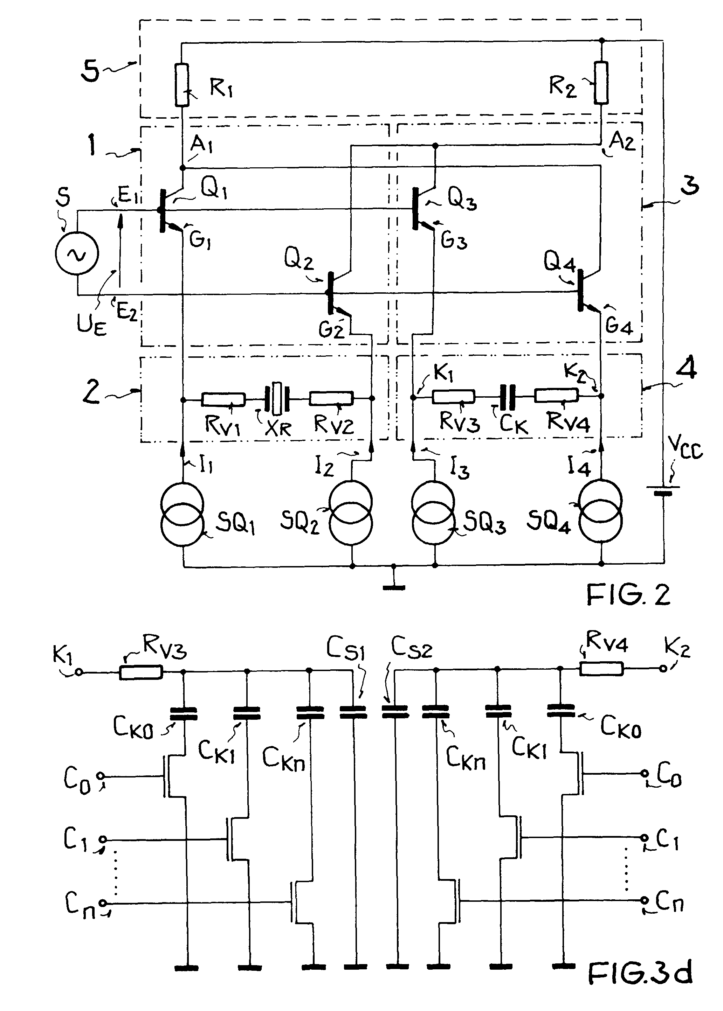

Die Fig. 3 zeigt einige Beispiele für die Ausbildung der Kompensationsschaltung bei Verwendung von Kompensationskondensatoren.
In einer integrierten Schaltung ist eine Elektrode eines Kondensators stets mit einer parasitären Substratkapazität belastet. Um trotzdem eine symmetrische Gesamtkapazität zu erreichen, wird gemäß Figur 3a die Gesamtkapazität des Kondensators C_{K} in die Kapazitäten der beiden antiparallel verbundenen Kondensatoren C_{K1} und C_{K2} aufgeteilt, so daß der erste Anschluß K₁ mit der Substratkapazität C_{S1} und der zweite Anschluß K₂ mit der Substratkapazität C_{S2} des jeweils zugeordneten Kondensators C_{K1}, C_{K2} belastet ist. Infolge des symmetrischen Betriebes stört der Substratanteil nicht, sondern trägt vielmehr mit 1/(1/C_{S1}+1/C_{S2}) zur Gesamtkapazität bei.
Eine andere Möglichkeit ist die Reihenschaltung zweier Kondensatoren C_{K1}, C_{K2} nach Figur 3b; bei symmetrischen Signalen ist es hierbei ohne Bedeutung, ob der Verbindungspunkt mit Bezugspotential verbunden ist oder nicht. Da der Kompensationskondensator C_{K} häufig relativ kleine Kapazitätswerte aufweist und somit parasitäre Einflüsse reduziert werden, erleichtert diese Ausführungsform die technische Realisierung.
Integrationstechnisch können - wie in Figur 3c dargestellt - die beiden Kondensatoren C_{K1}, C_{K2} zu einer Struktur vereinigt werden. Die gemeinsame Gegenelektrode der beiden Kondensatoren C_{K1}, C_{K2} ist symbolisch über eine Sperrschicht mit Masse verbunden.
Die in der Figur 3d dargestellte Ausführungsform zeigt eine Kompensationsschaltung mit digitalem Abgleich. Über elektronische Schalter werden Kondensatoren C_{K0}, C_{K1}, ..., C_{Kn} mit unterschiedlichen Kapazitätswerten zu- oder weggeschaltet. Die Eingänge C₀, C₁, ..., Cₙ der Schalter können über einen Microcontroller angesteuert werden oder über eine Bondoption (Einmalabgleich) festgelegt werden. Die Kapazitätswerte der densatoren werden beispielsweise zu C_{K1} = 2¹·C_{K0}, ..., C_{Kn} = 2ⁿ·C_{K0} gewichtet.

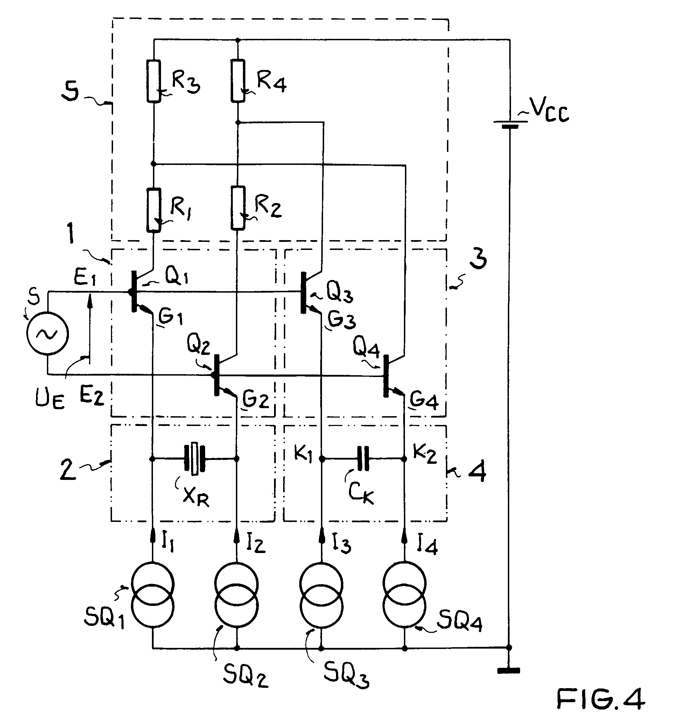

Die in der Figur 2 vorgestellte Schaltung ist von Natur aus rauscharm, weil das Rauschen eines Emitterwiderstandes (R₁, R₂) im Idealfall gleich dem Rauschen eines nur halb so großen Widerstandes ist. Um das von der Kompensationsschaltung verursachte zusätzliche Rauschen zu vermindern, kann eine Schaltungsanordnung gemäß der Figur 4 vorgesehen werden: hier werden die Arbeitswiderstände R₁, R₂ der Auswerteschaltung 5 aufgeteilt und die Ausgangsanschlüsse A₁, A₂ der zweiten Differenzstufe 3 (dies sind die Kollektoren der Transistoren Q₃, Q₄, die den Kompensationsstrom führen), an die Teilerwiderstände R₃, R₄ angeschlossen. Die Wirkung des pensationsstromes wird dann um das Verhältnis R₃/(R₁+R₃) vermindert und muß durch einen entsprechend größeren Kapazitätswert des Kompensationskondensators C_{K} ausgeglichen werden; gegebenenfalls können hierzu auch die Versorgungsströme I₃, I₄ vergrößert werden.

## Patentansprüche

1. Filterschaltung mit einem in Serienresonanz betriebenen Resonator, bestehend aus:
a) einer Zweipol-Resonatorschaltung (2) mit einem Resonator (X_{R}), dessen Leitwert (L_{R}) in einen Nutzanteil (L_{N}) und einen parasitären Anteil (L_{P}) geteilt werden kann,
b) einer von einer Signalquelle (S) angesteuerten ersten Differenzstufe (1) mit zwei aktiven Elementen (Q₁, Q₂) deren Grundanschluß (G₁, G₂) jeweils mit einer Stromquelle (SQ₁, SQ₂) und einem Anschluß der Zweipol-Resonatorschaltung (2) verbunden ist,
c) einer zwei Anschlüsse aufweisenden Kompensationsschaltung (4), die den parasitären Anteil (L_{P}) des Resonator-Leitwerts (L_{R}) nachbildet,
d) einer von der Signalquelle (S) angesteuerten und zur ersten Differenzstufe (1) gleichartigen zweiten Differenzstufe (3) mit zwei aktiven Elementen (Q₃, Q₄), deren Grundanschluß (G₃, G₄) jeweils mit einer Stromquelle (SQ₃, SQ₄) und einem Anschluß der Kompensationsschaltung (4) verbunden ist,
e) einer mit den beiden, gegeneinander vertauschten Ausgangsanschlüssen (A₁, A₂) der beiden Differenzstufen (1, 3) verbundenen Auswerteschaltung (5).

2. Filterschaltung nach Anspruch 1, dadurch gekennzeichnet, daß die Zweipol-Resonatorschaltung (2) einen piezoelektrischen Resonator (X_{R}) aufweist.

3. Filterschaltung nach Anspruch 2, dadurch gekennzeichnet, daß die Zweipol-Resonatorschaltung (2) mindestens einen Vorwiderstand (R_{V1}, R_{V2}) aufweist, und daß die Vorwiderstände (R_{V1}, R_{V2}) einseitig oder beidseitig mit dem piezoelektrischen Resonator (X_{R}) verbunden sind.

4. Filterschaltung nach einem der Ansprüche 1 bis 3, dadurch gekennzeichnet, daß die Kompensationsschaltung (4) einen Kondensator (C_{K}) bzw. eine Kondensatorschaltung aufweist.

5. Filterschaltung nach Anspruch 4, dadurch gekennzeichnet, daß die Kompensationsschaltung (4) mindestens einen Vorwiderstand (R_{V3}, R_{V4}) aufweist, und daß die Vorwiderstände (R_{V3}, R_{V4}) einseitig oder beidseitig mit dem Kompensationskondensator (C_{K}) oder der Kondensatorschaltung verbunden sind.

6. Filterschaltung nach Anspruch 4 oder 5, dadurch gekennzeichnet, daß die Kondensatorschaltung als parallelschaltung zweier integrierter Kondensatoren (C_{K1}, C_{K2}) mit Substratanteil (C_{S1}, C_{S2}) ausgebildet ist.

7. Filterschaltung nach Anspruch 4 oder 5, dadurch gekennzeichnet, daß die Kondensatorschaltung als Reihenschaltung zweier integrierter Kondensatoren (C_{K1}, C_{K2}) mit Substratanteil (C_{S1}, C_{S2}) ausgebildet ist, wobei der Verbindungspunkt der beiden Kondensatoren (C_{K1}, C_{K2}) die Substrat-Anteile (C_{S1}, C_{S2}) parallel schaltet und mit Bezugspotential verbunden sein kann.

8. Filterschaltung nach Anspruch 4 oder 5, dadurch gekennzeichnet, daß die Kondensatorschaltung mehrere zelkondensatoren (C_{K0}, C_{K1}, C_{Kn}) mit unterschiedlichen Kapazitätswerten aufweist, wobei die einzelnen Kondensatoren (C_{K0}, C_{K1}, C_{Kn}) über elektronische Schalter zuoder weggeschaltet werden.

9. Filterschaltung nach einem der Ansprüche 1 bis 8, dadurch gekennzeichnet, daß die Auswerteschaltung (5) durch Widerstände (R₁, R₂) realisiert ist.

10. Filterschaltung nach Anspruch 9, dadurch gekennzeichnet, daß die Auswerteschaltung (5) zwei weitere Widerstände (R₃, R₄) aufweist, von denen jeweils einer in Reihe zu den beiden ersten Widerständen (R₁, R₂) geschaltet ist, und daß der Verbindungspunkt der Widerstände (R₁, R₃ bzw. R₂, R₄) jeweils mit einem Ausgangsanschluß (A₁ bzw. A₂) der zweiten Differenzstufe (3) verbunden ist.

11. Filterschaltung nach einem der Ansprüche 1 bis 8, dadurch gekennzeichnet, daß die Auswerteschaltung (5) durch eine Stromspiegelschaltung realisiert ist.

12. Filterschaltung nach einem der Ansprüche 1 bis 11, dadurch gekennzeichnet, daß die Bandbreite der Filterschaltung über die Wahl der Versorgungsströme (I₁, I₂, I₃, I₄) der Stromquellen (SQ₁, SQ₂, SQ₃, SQ₄) einstellbar ist.

13. Filterschaltung nach einem der Ansprüche 1 bis 12, dadurch gekennzeichnet, daß der Kompensationseffekt der Filterschaltung über die Wahl der Versorgungsströme (I₃, I₄) der Stromquellen (SQ₃, SQ₄) abgleichbar ist.

14. Filterschaltung nach einem der Ansprüche 1 bis 13, dadurch gekennzeichnet, daß wenigstens zwei Filterschaltungen mit zwei Signalquellen ausgangsseitig parallel geschaltet sind, und daß der Signalpfad durch Zuschalten oder Abschalten der Stromquellen (SQ₁, SQ₂, SQ₃, SQ₄) umschaltbar ist.

15. Filterschaltung nach einem der Ansprüche 1 bis 14, dadurch gekennzeichnet, daß die aktiven Elemente (Q₁, Q₂, Q₃, Q₄) der beiden Differenzstufen (1, 3) als Bipolartransistoren ausgebildet sind, wobei die Basen der Transistoren (Q₁, Q₃ bzw. Q₂, Q₄) die beiden Eingangsanschlüsse (E₁ bzw. E₂) der beiden Differenzstufen (1, 3) bilden, die Kollektoren der Transistoren (Q₁, Q₄ bzw. Q₂, Q₃) die beiden Ausgangsanschlüsse (A₁ bzw. A₂) der beiden Differenzstufen (1, 3) bilden und die Emitter der Transistoren (Q₁, Q₂, Q₃, Q₄) die Grundanschlüsse (G₁, G₂, G₃, G₄) der beiden Differenzstufen (1, 3) bilden.

16. Filterschaltung nach einem der Ansprüche 1 bis 14, dadurch gekennzeichnet, daß die aktiven Elemente (Q₁,
Q₂, Q₃, Q₄) der beiden Differenzstufen (1, 3) als effekttransistoren ausgebildet sind, wobei die Gates der Transistoren (Q₁, Q₃ bzw. Q₂, Q₄) die beiden Eingangsanschlüsse (E₁ bzw. E₂) der beiden Differenzstufen (1, 3) bilden, die Drains der Transistoren (Q₁, Q₄ bzw. Q₂, Q₃) die beiden Ausgangsanschlüsse (A₁ bzw. A₂) der beiden Differenzstufen (1, 3) bilden und die Sources der Transistoren (Q₁, Q₂, Q₃, Q₄) die Grundanschlüsse (G₁, G₂, G₃, G₄) der beiden Differenzstufen (1, 3) bilden.

## Claims

1. A filter circuit with a resonator operated in series resonance comprising:
a) a two-terminal resonator circuit (2) with a resonator (X_{R}) whose conductance (L_{R}) can be split into a useful component (L_{N}) and a parasitic component (L_{P}),
b) a first difference stage (1) driven by a signal source (S) and having two active elements (Q₁, Q₂) whose base terminal (G₁, G₂) is in each case connected to a current source (SQ₁, SQ₂) and to one terminal of the two-terminal resonator circuit (2),
c) a compensation circuit (4) which has two terminals and which simulates the parasitic component (L_{P}) of the resonator conductance (L_{R}),
d) a second difference stage (3), driven by the signal source (S), corresponding to the first difference stage (1) and having two active elements (Q₃, Q₄), whose base terminal (G₃, G₄) is in each case connected to a current source (SQ₃, SQ₄) and to a terminal of the compensation circuit (4),
e) an evaluation circuit (5) connected to the two mutually transposed output terminals (A₁, A₂) of the two difference stages (1, 3).

2. A filter circuit according to Claim 1, characterised in that the two-terminal resonator circuit (2) comprises a piezoelectric resonator (X_{R}).

3. A filter circuit according to Claim 2, characterised in that the two-terminal resonator circuit (2) comprises at least one series resistor (R_{V1}, R_{V2}) and that the series resistors (R_{V1}, R_{V2}) are connected on one side or both sides to the piezoelectric resonator (X_{R}).

4. A filter circuit according to one of Claims 1 to 3, characterised in that the compensation circuit (4) comprises a capacitor (C_{K}) or a capacitor circuit.

5. A filter circuit according to Claim 4, characterised in that the compensation circuit (4) comprises at least one series resistor (R_{V3}, R_{V4}) and that the series resistors (R_{V3}, R_{V4}) are connected on one side or both sides to the compensation capacitor (C_{K}) or the capacitor circuit.

6. A filter circuit according to Claim 4 or 5, characterised in that the capacitor circuit has the form of an antiparallel circuit comprising two integrated capacitors (c_{K1}, C_{K2}) with substrate component (C_{S1}, C_{S2}).

7. A filter circuit according to Claim 4 or 5, characterised in that the capacitor circuit has the form of a series circuit comprising two integrated capacitors (c_{K1}, C_{K2}) with substrate components (C_{S1}, C_{S2}), where the connection point of the two capacitors (C_{K1}, C_{K2}) connects the substrate components (C_{S1}, C_{S2}) in parallel and can be connected to reference potential.

8. A filter circuit according to Claim 4 or 5, characterised in that the capacitor circuit comprises a plurality of individual capacitors (C_{K0}, C_{K1}, C_{Kn}) with different capacitance values, where the individual capacitors (C_{K0}, C_{K1}, C_{Kn}) are switched on or off via electronic switches.

9. A filter circuit according to one of Claims 1 to 8, characterised in that the evaluation circuit (5) is formed by resistors (R₁, R₂).

10. A filter circuit according to Claim 9, characterised in that the evaluation circuit (5) comprises two further resistors (R₃, R₄), one of which is in each case connected in series to the two first resistors (R₁, R₂), and that the connection point of the resistors (R₁, R₃ and, R₂, R₄) is in each case connected to an output terminal (A₁ and A₂) of the second difference stage (3).

11. A filter circuit according to one of Claims 1 to 8, characterised in that the evaluation circuit (5) is formed by a current mirror circuit.

12. A filter circuit according to one of Claims 1 to 11, characterised in that the band width of the filter circuit can be set via the selection of the supply currents (I₁, I₂, I₃, I₄) of the current sources (SQ₁, SQ₂, SQ₃, SQ₄).

13. A filter circuit according to one of Claims 1 to 12, characterised in that the compensation effect of the filter circuit is adjustable via the selection of the supply currents (I₃, I₄) of the current sources (SQ₃, SQ₄).

14. A filter circuit according to one of Claims 1 to 13, characterised in that at least two filter circuits with two signal sources are connected in parallel at their output end, and that the signal path can be switched over by the switching on or off of the current sources (SQ₁, SQ₂, SQ₃, SQ₄).

15. A filter circuit according to one of Claims 1 to 14, characterised in that the active elements (Q₁, Q₂, Q₃, Q₄) of the two difference stages (1, 3) are designed as bipolar transistors, where the bases of the transistors (Q₁, Q₃ and Q₂, Q₄) form the two input terminals (E₁ and E₂) of the two difference stages (1, 3), the collectors of the transistors (Q₁, Q₄, and Q₂, Q₃) form the two output terminals (A₁ and A₂) of the two difference stages (1, 3) and the emitters of the transistors ((Q₁, Q₂, Q₃, Q₄) form the base terminals (G₁, G₂, G₃, G₄) of the two difference stages (1, 3).

16. A filter circuit according to one of Claims 1 to 14, characterised in that the active elements (Q₁, Q₂, Q₃, Q₄) of the two difference stages (1, 3) are designed as field effect transistors, where the gates of the transistors (Q₁, Q₃ and Q₂, Q₄) form the two input terminals (E₁ and E₂) of the two difference stages (1, 3), the drains of the transistors (Q₁, Q₄ and Q₂, Q₃) form the two output terminals (A₁ and A₂) of the two difference stages (1, 3) and the sources of the transistors (Q₁, Q₂, Q₃, Q₄) form the base terminals (G₁, G₂, G₃, G₄) of the two difference stages (1, 3).

## Revendications

1. Circuit de filtrage comportant un résonateur fonctionnant en résonance série, constitué de:
a) un circuit résonateur à deux pôles (2) comprenant un résonateur (X_{R}) dont la conductance (L_{R}) peut se répartir en une partie utile (L_{N}) et une partie parasite (L_{P}),
b) un premier étage différentiateur (1), commandé par une source de signaux (S) et comportant deux éléments actifs (K1, K2) dont la borne de commande (G1, G2) est respectivement reliée à une source de courant (SQ1, SQ2) et à une borne du circuit résonateur à deux pôles (2),
c) un circuit de compensation (4) qui présente deux bornes et équilibre la partie parasite (LP) de la conductance (LR) du résonateur,
d) un second circuit différentiateur (3), qui est commandé par la source de signaux (S), est identique au premier étage différentiateur (1) et comporte deux éléments actifs (Q₃, Q₄) dont la borne de commande (G₃, G₄) est respectivement reliée à une source de courant (S_{Q3}, S_{Q4}) et à une borne du circuit de compensation (4),
e) un circuit de traitement (5) relié aux deux bornes de sortie A₁, A₂, échangées l'une par rapport à l'autre, des deux étages différentiateurs (1, 3).

2. Circuit de filtrage selon la revendication 1, caractérisé par le fait que le circuit résonateur à deux pôles (2) présente un résonateur piézo-électrique (X_{R}).

3. Circuit de filtrage selon la revendication 2, caractérisé par le fait que le circuit résonateur à deux pôles (2) présente au moins une prérésistance (R_{V1}, R_{V2}) et que les prérésistances (R_{V1}, R_{V2}) sont reliées, d'un côté ou des deux côtés, au résonateur piézo-électrique (X_{R})

4. Circuit de filtrage selon l'une des revendications 1 à 3, caractérisé par le fait que le circuit de compensation (4) présente un condensateur (CK) ou un circuit de condensateur.

5. Circuit de filtrage selon la revendication 4, caractérisé par le fait que le circuit de compensation (4) présente au moins une prérésistance (R_{V3}, R_{V4}) et que les prérésistances sont reliées, d'un côté ou des deux côtés, au condensateur de compensation (C_{K}) ou au circuit de condensateur.

6. Circuit de filtrage selon la revendication 4 ou 5, caractérisé par le fait que le circuit de condensateur est conçu sous forme de montage tête-bêche de deux condensateurs intégrés (C_{K1}, C_{K2}) de capacité de substrat (C_{S1}, C_{S2}).

7. Circuit de filtrage selon la revendication 4 ou 5, caractérisé par le fait que le circuit de condensateur est conçu sous forme de montage série de deux condensateurs intégrés (C_{K1}, C_{K2}) de capacité de substrat (C_{S1}, C_{S2}), le point de liaison des deux condensateurs (C_{K1}, C_{K2}) étant monté en parallèle avec les capacités de substrat (C_{S1}, C_{S2}) et pouvant être relié au potentiel de référence.

8. Circuit de filtrage selon la revendication 4 ou 5, caractérisé par le fait que le circuit de condensateurs présente plusieurs condensateurs individuels (C_{K0}, C_{K1}, C_{Kn}) de valeurs de capacité différentes, les différents condensateurs (C_{K0}, C_{K1}, C_{Kn}) étant, ou non, reliés au moyen d'interrupteurs électroniques.

9. Circuit de filtrage selon l'une des revendications 1 à 8, caractérisé par le fait que le circuit de traitement (5) est réalisé par des résistances (R₁, R₂),

10. Circuit de filtrage selon la revendication 9, caractérisé par le fait que le circuit de traitement (5) présente deux autres résistances (R₃, R₄) dont chacune est montée en série avec les deux premières résistances (R₁, R₂) et que chacun des points de liaison des résistances (R₁, R₃ ou R₂, R₄) est relié à une borne de sortie (A₁ ou A₂) du second étage différentiateur (3).

11. Circuit de filtrage selon l'une des revendications 1 à 8, caractérisé par le fait que le circuit de traitement (5) est réalisé par un circuit miroir de courant.

12. Circuit de filtrage selon l'une des revendications 1 à 11, caractérisé par le fait que l'on peut prescrire la largeur de bande du circuit de filtrage par le choix des courants d'alimentation (I₂, I₃, I₄) des sources de courant (S_{Q1}, S_{Q2}, S_{Q3}, S_{Q4}).

13. Circuit de filtrage selon l'une des revendications 1 à 12, caractérisé par le fait que l'on peut équilibrer l'effet de compensation des circuits de filtrage par le choix des courants d'alimentation (I₃, I₄) des sources de courant (S_{Q3}, S_{Q4}).

14. Circuit de filtrage selon l'une des revendications 1 à 13, caractérisé par le fait qu'au moins deux circuits de filtrage comprenant deux sources de signaux sont montés en parallèle du côté de la sortie et que l'on peut faire commuter le chemin du signal en ajoutant des sources de courant (S_{Q1}, S_{Q2}, S_{Q3}, S_{Q4}) au circuit ou en en enlevant.

15. Circuit de filtrage selon l'une des revendications 1 à 14, caractérisé par le fait que les éléments actifs (Q₁, Q₂, Q₃, Q₄) des deux étages différentiateurs (1, 3) sont conçus sous forme de transistors bipolaires, les bases des transistors (Q₁, Q₃ ou Q₂, Q₄) formant les deux bornes d'entrée (E₁ ou E₂ des deux étages différentiateurs (1, 3), les collecteurs des transistors (Q₁, Q₄ ou Q₂, Q₃) formant les deux bornes de sortie (A₁ ou A₂) des deux étages différentiateurs (1, 3) et les émetteurs des transistors (Q₁, Q₂, Q₃, Q₄) formant les bornes de commande (G₁, G₂, G₃, G₄) des deux étages différentiateurs (1, 3).

16. Circuit de filtrage selon l'une des revendications 1 à 14, caractérisé par le fait que les éléments actifs (Q₁, Q₂, Q₃, Q₄) des deux étages différentiateurs (1, 3) sont conçus sous forme de transistors à effet de champ, les grilles des transistors (Q₁, Q₃ ou Q₂, Q₄) formant les deux bornes d'entrée (E₁ ou E₂ des deux étages différentiateurs (1, 3), les drains des transistors (Q₁, Q₄ ou Q₂, Q₃) formant les deux bornes de sortie (A₁ ou A₂) des deux étages différentiateurs (1, 3) et les sources des transistors (Q₁, Q₂, Q₃, Q₄) formant les bornes de commande (G₁, G₂, G₃, G₄) des deux étages différentiateurs (1, 3).
